# EUROPEAN PATENT APPLICATION

(11) **EP 4 745 437 A1**
(43) Date of publication of application: **20.05.2026**
(21) Application number: 25214019.9
(22) Date of filing: 06.11.2025
(51) Int. Cl.: F16K 11/085, F16K 27/00, F16K 27/06, F16K 27/10, F16K 27/12, F01P 7/14

(54) **COOLING MODULE**

(30) Priority: 13.11.2024 JP 2024198461
(71) Applicant: AISIN CORPORATION, Aichi 448-8650 (JP)
(72) Inventor: OSUKA, Shinya, Kariya, 448-8650 (JP); KUROZUMI, Takashi, Kariya, 448-8650 (JP); ISHIKAWA, Katsuhiro, Kariya, 448-8650 (JP); KATAOKA, Akihiro, Kariya, 448-8650 (JP)
(74) Representative: Winter, Brandl - Partnerschaft mbB

(57) **Abstract**

There is provided a cooling module (1) that enables a cooling liquid to efficiently circulate in a manifold (M). The cooling module (1) includes a resin manifold (M) having a coolant flow path through which a cooling fluid circulates, the manifold (M) is formed by joining a first housing (10) and a second housing (30), each of which includes three-dimensionally curved portion (16A, 16B, 17A, 17B, 25A, 25B), and a bonded surface (Ma) of the first housing (10) and a bonded surface (Mb) of the second housing (30) include at least a part having a curved surface (Mal, Mbl).

## Description

### TECHNICAL FIELD

This disclosure generally relates to a cooling module.

### BACKGROUND DISCUSSION

In recent years, automobiles equipped with an electric motor as a driving source have been widespread, such as a hybrid electric vehicle (HEV), a plug-in hybrid electric vehicle (PHEV), a battery electric vehicle (BEV), and a fuel cell electric vehicle (FCEV). These automobiles (hereinafter collectively referred to as an "electric vehicle") include a battery for driving the electric motor. Since the electric vehicle includes many devices that require cooling, such as an electric motor (including an internal-combustion engine such as an engine), a battery, an air conditioner, and an ECU, a cooling circuit for circulating cooling water is configured, and this circuit cools those devices.

WO2024/013871 (Reference 1) discloses a cooling module including a manifold that can be used for electric vehicles and the like. In the cooling module in Reference 1, the manifold is configured by joining a first housing and a second housing, and bonded surfaces of the first housing and the second housing are planar.

In a cooling module including a manifold, the manifold is formed by joining a plurality of housings. For example, in the cooling module described in Reference 1, a plurality of housings are joined at planar surfaces thereof. In the manifold formed in this manner, flexibility in shape of a flow path provided inside the manifold is restricted. Therefore, the flow path inside the manifold is likely to have a useless space, which may increase a pressure drop. Thus, a cooling module that causes a cooling liquid to circulate in a manifold has room for improvement.

A need thus exists for a cooling module that enables a cooling liquid to efficiently circulate in a manifold.

### SUMMARY

A cooling module according to this disclosure includes: a resin manifold having a coolant flow path through which a cooling fluid circulates, the manifold is formed by joining a first housing and a second housing, each of which includes a three-dimensionally curved portion, and a bonded surface of the first housing and a bonded surface of the second housing include at least a part having a curved surface.

In the cooling module of this configuration, each of the two housings includes a three-dimensionally curved portion, and the bonded surfaces of the two housings include at least a part having a curved surface, and as a result, the manifold has a three-dimensional shape. Consequently, flexibility in shape of a fluid flow path provided in the manifold is enhanced, and a useless space and a pressure drop in the manifold can be effectively reduced. In addition, temperature in the manifold can be efficiently controlled with a small amount of water. As a result, the cooling module can enable a cooling liquid to efficiently circulate in the manifold.

### BRIEF DESCRIPTION OF THE DRAWINGS

The foregoing and additional features and characteristics of this disclosure will become more apparent from the following detailed description considered with the reference to the accompanying drawings, wherein:
FIG. 1 is a perspective view of a cooling module;
FIG. 2 is an exploded perspective view of the cooling module;
FIG. 3 is a plan view of the cooling module;
FIG. 4 is a partially cross-sectional side view of the cooling module;
FIG. 5 is a partially cross-sectional perspective view illustrating a bonded state in a flow pipe; and
FIG. 6 is a partial plan view of the cooling module.

### DETAILED DESCRIPTION

An embodiment of a cooling module according to this disclosure is described in detail below with reference to the drawings. Embodiments to be described below are examples for describing this disclosure, and it is not intended to limit this disclosure to these embodiments. Therefore, this disclosure may be implemented in various forms without departing from the gist of this disclosure.

### (Configuration of cooling system)

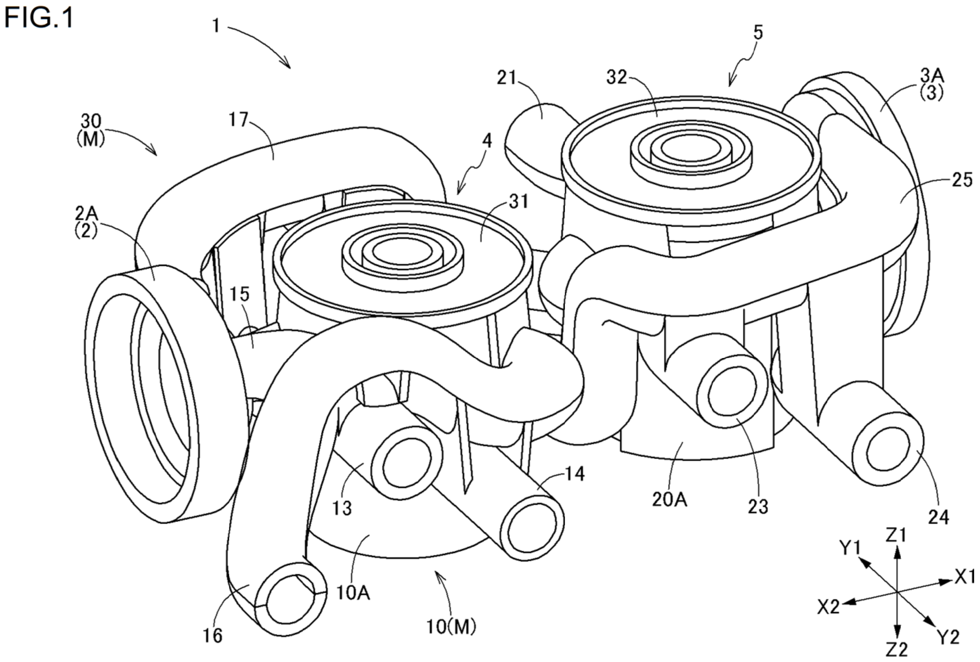

As illustrated in FIG. 1, a cooling system including a cooling module 1 according to this embodiment includes: a first water pump 2; a second water pump 3; a first rotary valve 4; a second rotary valve 5; a radiator; an inverter or electric motor; a DC-DC converter; a charger; a reserve tank; a heater core; an electric heater; a water-cooled condenser; a battery; a chiller; and a plurality of flow paths (an example of a coolant flow path) for circulating a cooling liquid (an example of a cooling fluid) through the components described above. The cooling liquid is a collective term for antifreeze the main ingredient of which is ethylene glycol or the like, cooling water such as a long life coolant, and a cooling oil consisting of an insulating oil such as a paraffinic oil. Among the components described above, the first water pump 2, the second water pump 3, the first rotary valve 4, and the second rotary valve 5 are attached to the cooling module 1. In contrast, the radiator, the inverter or electric motor, the DC-DC converter, the charger, the reserve tank, the heater core, the electric heater, the water-cooled condenser, the battery, and the chiller are disposed spaced apart from the cooling module 1 and configured in such a way that the cooling liquid is circulated among the cooling module 1 and these components through a plurality of the flow paths.

The cooling system is used in automobiles equipped with an electric motor as a driving source such as a hybrid electric vehicle (HEV), a plug-in hybrid electric vehicle (PHEV), a battery electric vehicle (BEV), and a fuel cell electric vehicle (FCEV) (hereinafter collectively referred to as an "electric vehicle"), and the cooling system circulates the cooling liquid and thus cools the inverter or electric motor, the battery, and the like.

### (Configuration of cooling module)

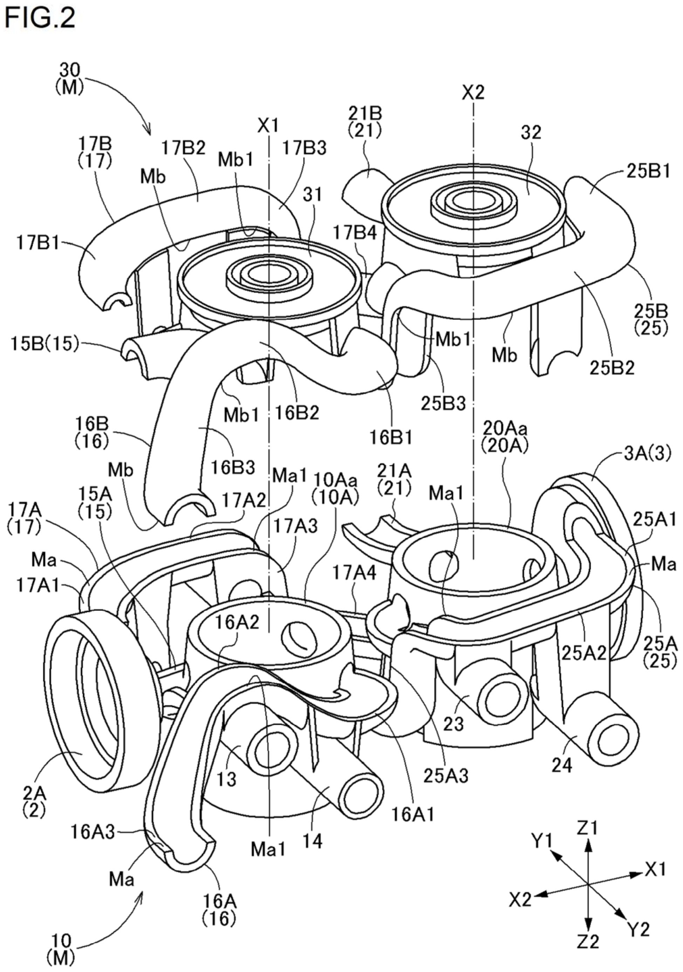

As illustrated in FIG. 1 to FIG. 4, the cooling module 1 includes: the first water pump 2; the second water pump 3; the first rotary valve 4; the second rotary valve 5; a manifold housing 10 (an example of a first housing) in which a flow path for distributing the cooling liquid to these components is formed; and a cover 30 (an example of a second housing). A resin manifold M is formed by resin-bonding the manifold housing 10 and the cover 30. The first water pump 2 and the second water pump 3 are respectively mounted on pump mounting sections 2A and 2B, although illustrations of the first water pump 2 and the second water pump 3 are omitted in FIG. 1 to FIG. 3. In FIG. 2, illustrations of the first rotary valve 4 and the second rotary valve 5 are omitted. In this embodiment, the manifold housing 10 is made of resin and formed of a single housing (an example of a "single member"). The cooling module 1 does not include a reserve tank inside. Because the cooling module 1 does not include a reserve tank, dimensions of the cooling module 1 can be reduced and flexibility in disposing the cooling module can be enhanced.

The manifold housing 10 includes two accommodating sections 10A and 20A and a plurality of cylindrically shaped flow paths (inlet ports 12, 21, 22, or the like to be described later). In the manifold housing 10, the accommodating sections 10A and 20A have a substantially cylindrical shape. Explanations are made below on condition that a direction in parallel to a direction in which the two accommodating sections 10A and 20A are arranged is defined as an X direction, a direction perpendicular to the X direction is defined as a Y direction, and a direction perpendicular to the X direction and the Y direction is defined as a Z direction. With regard to the X direction, a direction from the first water pump 2 toward the second water pump 3 is defined as an X1 direction, and a direction opposite to the X1 direction is defined as an X2 direction. With regard to the Y direction, a direction from a first outlet port 13 toward a first inlet port 11 is defined as a Y1 direction, and a direction opposite to the Y1 direction is defined as a Y2 direction (the first outlet port 13 and the first inlet port 11 are described later). With regard to the Z direction, a direction from the manifold housing 10 toward the cover 30 is defined as a Z1 direction, and a direction opposite to the Z1 direction is defined as a Z2 direction. The Z2 direction is the direction of gravity. In other words, the manifold housing 10 is disposed on a lower side with respect to the cover 30 in a vertical direction.

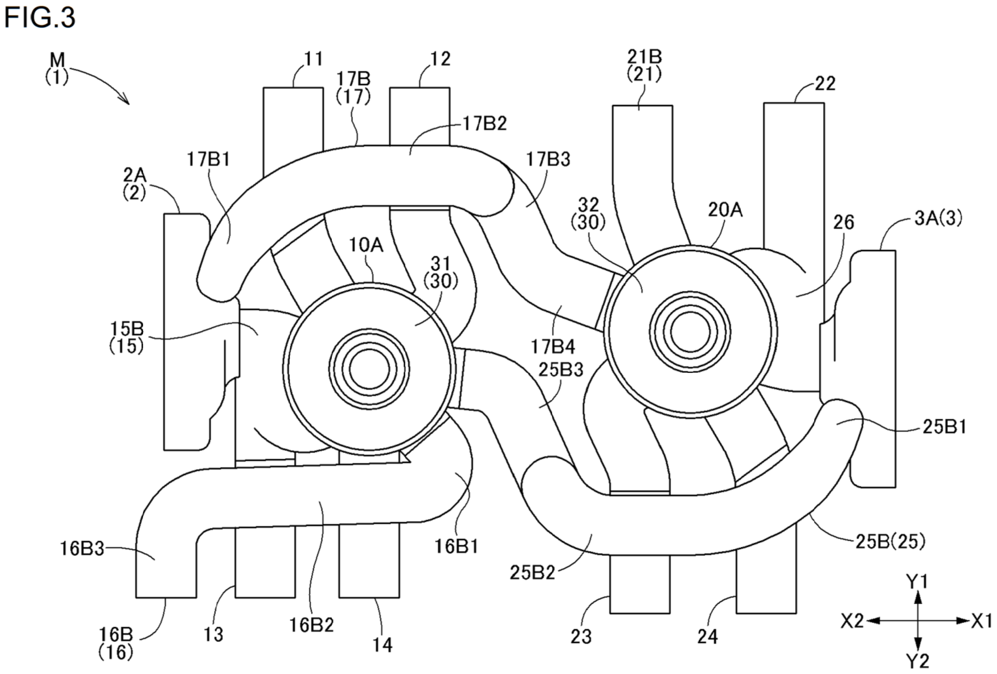

As illustrated in FIG. 3, the first inlet port 11, a second inlet port 12, the first outlet port 13, and a second outlet port 14 are connected to a first accommodating section 10A. A third inlet port 21, a fourth inlet port 22, a third outlet port 23, and a fourth outlet port 24 are connected to a second accommodating section 20A. In other words, one end of each of the first inlet port 11, the second inlet port 12, the first outlet port 13, and the second outlet port 14 opens toward an inner wall of the first accommodating section 10A while one end of each of the third inlet port 21, the fourth inlet port 22, the third outlet port 23, and the fourth outlet port 24 opens toward an inner wall of the second accommodating section 20A. All of the inlet ports 11, 12, and 22 and the outlet ports 13, 14, 23, and 24 are cylindrical. The third inlet port 21 is formed by joining a half-split pipe section 21A provided in the manifold housing 10 and a half-split pipe section 21B provided in the cover 30. The inlet ports 11, 12, 21, and 22 and the outlet ports 13, 14, 23, and 24 are arranged in parallel to one another in the X direction in such a way that axes of these ports are directed along the Y direction, and each of these ports has an opening that opens toward the Y1 direction or the Y2 direction.

The cooling module 1 includes a fifth outlet port 16 and flow pipes 15, 17, 25, and 26 respectively as another port and other flow pipes. The fifth outlet port 16 and the flow pipes 15, 17, 25, and 26 are respectively formed by joining half-split pipe sections 15A, 16A, 17A, 25A, and 26A provided in the manifold housing 10 and half-split pipe sections 15B, 16B, 17B, 25B, and 26B provided in the cover 30. All of the first inlet port 11, the second inlet port 12, the first outlet port 13, the second outlet port 14, the third inlet port 21, the fourth inlet port 22, the third outlet port 23, the fourth outlet port 24, the fifth outlet port 16, and the flow pipes 15, 17, 25, and 26 are exposed to an outside. All of the fifth outlet port 16 and the flow pipes 15, 17, 25, and 26 are cylindrical. In this embodiment, these ports and flow pipes constitute a part of a coolant flow path and are provided in such a way as to be exposed to the outside.

The fifth outlet port 16 is connected to the first accommodating section 10A at a position above the outlet ports 13 and 14. In the fifth outlet port 16, a proximal portion 16B1 is located on the X1 side with respect to the second outlet port 14 and a distal portion 16B3 is located on the X2 side with respect to the first outlet port 13.

A first flow pipe 15 is connected to the first water pump 2 and the first accommodating section 10A. A second flow pipe 26 is connected to the second water pump 3 and the second accommodating section 20A. A third flow pipe 17 is connected to the first water pump 2 and the second accommodating section 20A. A fourth flow pipe 25 is connected to the second water pump 3 and the first accommodating section 10A.

All of the fifth outlet port 16 and the flow pipes 17 and 25 have a three-dimensional shape that is deformed in the X direction, the Y direction, and the Z direction. Specifically, in the fifth outlet port 16, a proximal portion 16A1 and the proximal portion 16B1 are formed in such a way as to extend substantially in parallel to an X-Y plane and intersect with both the X1 direction and the Y2 direction, and intermediate portions 16A2 and 16B2 extend in the X2 direction from distal ends of the proximal portions 16A1 and 16B1. The intermediate portions 16A2 and 16B2 are convex in the Z1 direction. A distal portion 16A3 and the distal portion 16B3 are formed toward the Y2 direction from distal ends of the intermediate portions 16A2 and 16B2. In the third flow pipe 17, proximal portions 17A1 and 17B1 are formed in such a way as to extend substantially in parallel to the X-Y plane and intersect with both the X1 direction and the Y1 direction, first intermediate portions 17A2 and 17B2 are formed from distal ends of the proximal portions 17A1 and 17B1 toward the X1 direction, second intermediate portions 17A3 and 17B3 are formed from distal ends of the first intermediate portions 17A2 and 17B2 in a direction that intersects with all of the X1 direction, the Y1 direction, and the Z2 direction, and distal portions 17A4 and 17B4 are formed from distal ends of the second intermediate portions 17A3 and 17B3 in such a way as to extend substantially in parallel to the X-Y plane and intersect with both the X1 direction and the Y2 direction. In the fourth flow pipe 25, proximal portions 25A1 and 25B1 are formed in such a way as to extend substantially in parallel to the X-Y plane and intersect with both the X2 direction and the Y2 direction, first intermediate portions 25A2 and 25B2 are formed from distal ends of the proximal portions 25A1 and 25B1 toward the X2 direction, second intermediate portions 25A3 and 25B3 are formed from distal ends of the first intermediate portions 25A2 and 25B2 in a direction in such a way as to intersect with all of the X2 direction, the Y1 direction, and the Z2 direction, and distal portions 25A4 and 25B4 are formed from distal ends of the second intermediate portions 25A3 and 25B3 toward the X2 direction. The portions of the fifth outlet port 16 and the portions of the flow pipes 17 and 25 (for example, the proximal portions 16A1 and 16B1 as well as the intermediate portions 16A2 and 16B2) are individually connected through two-dimensional or three-dimensional curved portions.

The cover 30 includes, in addition to the half-split pipe sections 15B, 16B, 17B, 21B, 25B, and 26B, a first lid section 31 that covers an opening 10Aa of the first accommodating section 10A, and a second lid section 32 that covers an opening 20Aa of the second accommodating section 20A. The cover 30 is made of resin and formed by using, for example, a resin material (first resin material) that is the same as that of the manifold housing 10.

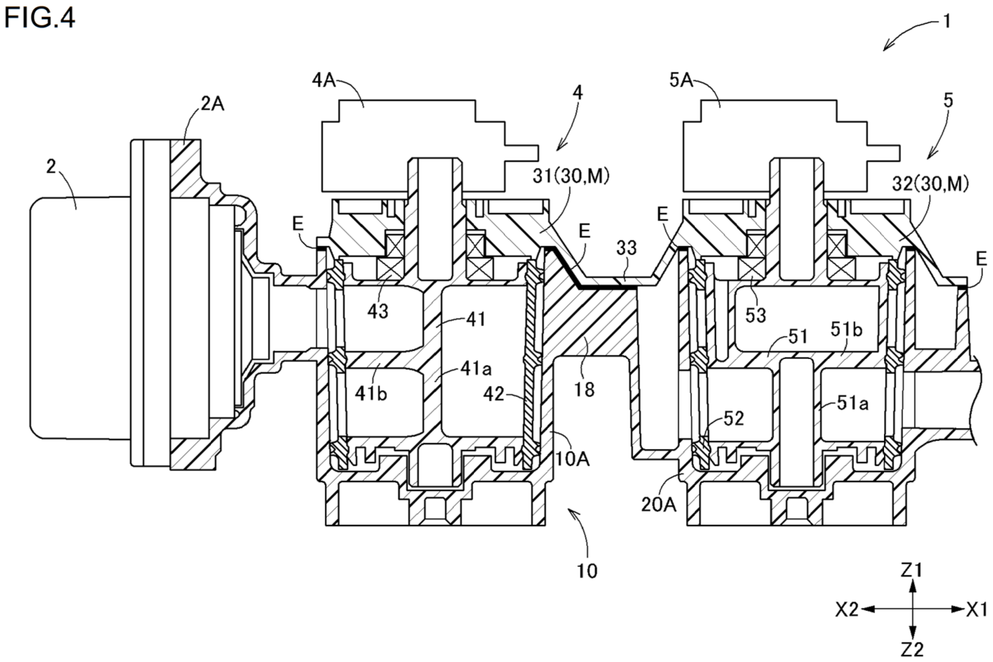

As illustrated in FIG. 4, as the rotary valves 4 and 5, for example, rotors for valves 41 and 51, rotor seals 42 and 52, and rod seals 43 and 53 are respectively accommodated in the accommodating sections 10A and 20A provided in the manifold housing 10. The rotors for valves 41 and 51 respectively include shaft portions 41a and 51a and flow path partitioning portions 41b and 51b intersecting with the shaft portions 41a and 51a. The rotors for valves 41 and 51 are individually rotatably supported by a concave portion formed in an underside of the accommodating sections 10A and 20A, the rotor seals 42 and 52 provided inside the lid sections 31 and 32, and the like. Above the rotors for valves 41 and 51, actuators 4A and 5A for driving the rotors for valves 41 and 51 are respectively disposed. Both of the first rotary valve 4 and the second rotary valve 5 are solenoid valves that enable flow paths to be switched using the actuators 4A and 5A, and by rotating the rotors for valves 41 and 51 respectively about axes X1 and X2 extending along the Z direction and switching the flow path, flow of the cooling liquid that circulates through a plurality of the flow paths is controlled.

As illustrated in FIG. 1 to FIG. 4, the manifold housing 10 includes the pump mounting sections 2A and 3A on each side in the X direction, and the first water pump 2 and the second water pump 3 are respectively mounted on the pump mounting section 2A and the pump mounting section 3A. The first water pump 2 and the second water pump 3 are respectively disposed in such a way that a rotation axis thereof extends along the X direction.

As illustrated in FIG. 4, in the cooling module 1, the resin manifold housing 10 and the resin cover 30 are resin-bonded after disposing the cover 30 at a position where the accommodating sections 10A and 20A are covered, and the cooling module 1 includes resin-bonded regions E between the resin manifold housing 10 and the resin cover 30. In this embodiment, the manifold housing 10 and the cover 30 are formed of the first resin material and the resin-bonded regions E are formed of a second resin material that is different from the first resin material. While methods for resin-bonding the manifold housing 10 and the cover 30 include, for example, bonding using an adhesive and molding by means of the DSI (Die Slide Injection) method, the DSI method is employed in this embodiment. Resin-bonding by means of the DSI method enables components of the rotary valves 4 and 5 such as the rotors for valves 41 and 51, the rotor seals 42 and 52, and rod seals 43 and 53 to be inserted into the accommodating sections 10A and 20A before performing the DSI process, and by subsequently resin-bonding the manifold housing 10 and the cover 30 by means of the DSI method, the openings of the two accommodating sections 10A and 20A can be covered at the same time. In this case, the second resin material of the resin-bonded regions E is a resin used in the DSI method. It should be noted that in FIG. 4, the section of the manifold housing 10 where the accommodating section 10A communicates with the accommodating section 20A is simplified and depicted using a resin section 18.

As illustrated in FIG. 2, the half-split pipe sections 16A, 17A, and 25A of the fifth outlet port 16 and the flow pipes 17 and 25 correspond to the three-dimensionally curved portions in the manifold housing 10, and a bonded surface Ma includes a curved surface Ma1. The half-split pipe sections 16B, 17B, and 25B of the fifth outlet port 16 and the flow pipes 17 and 25 correspond to the three-dimensionally curved portions in the cover 30, and a bonded surface Mb includes a curved surface Mb1. In other words, each of the bonded surface Ma of the manifold housing 10 and the bonded surface Mb of the cover 30 includes at least a portion having the curved surface Ma1 and Mb1. In this embodiment, the fifth outlet port 16 and the flow pipes 17 and 25 correspond to circular pipe sections.

The bonded surfaces Ma of the half-split pipe sections 16A, 17A, and 25A in the manifold housing 10 and the bonded surfaces Mb of the half-split pipe sections 16B, 17B, and 25B in the cover 30 are resin-bonded using the resin-bonded region E similarly to other sections. When joining the manifold housing 10 and the cover 30 by means of the DSI method, the second resin material of the resin-bonded regions E between the half-split pipe sections 16A, 16B, 17A, 17B, 25A, and 25B is also the resin used in the DSI method.

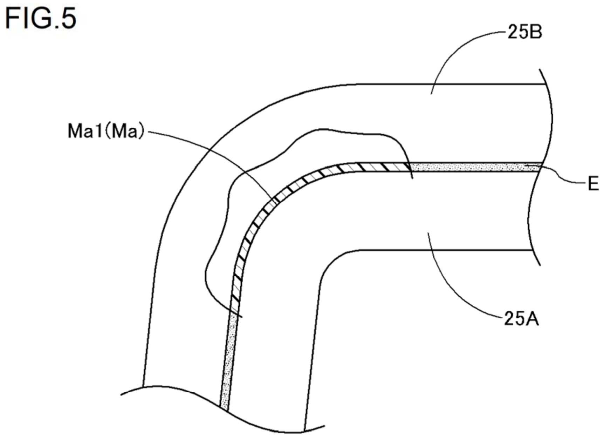

FIG. 5 illustrates a bonded state in the flow pipe 25. As illustrated in FIG. 5, in the flow pipe 25, the half-split pipe section 25A of the manifold housing 10 and the half-split pipe section 25B of the cover 30 are joined after forming the resin-bonded regions E between the three-dimensionally curved bonded surfaces Ma and MB in such a way as to extend along shapes (planar or curved surfaces) of these bonded surfaces Ma and Mb. Joining the bonded surfaces Ma and Mb each including at least a portion having the curved surface Ma1 and Mb2 may be relatively easily achieved by means of the DSI method.

In the cooling module 1 according to this embodiment as illustrated in FIG. 4, the cover 30 is resin-bonded to the manifold housing 10 at the resin-bonded region E, and the openings 10Aa and 20Aa of the accommodating sections 10A and 20A (see FIG. 2) are covered by the cover 30. Consequently, the cooling module 1 does not require another member such as a bolt for joining the manifold housing 10 and the cover 30. As a result, a height of the cooling module 1 can be reduced and the number of components can be reduced.

In the cooling module 1 according to this embodiment as illustrated in FIG. 4, the manifold housing 10 is constituted of a single member. Therefore, dead space generated in the flow path formed inside the manifold housing 10 can be reduced.

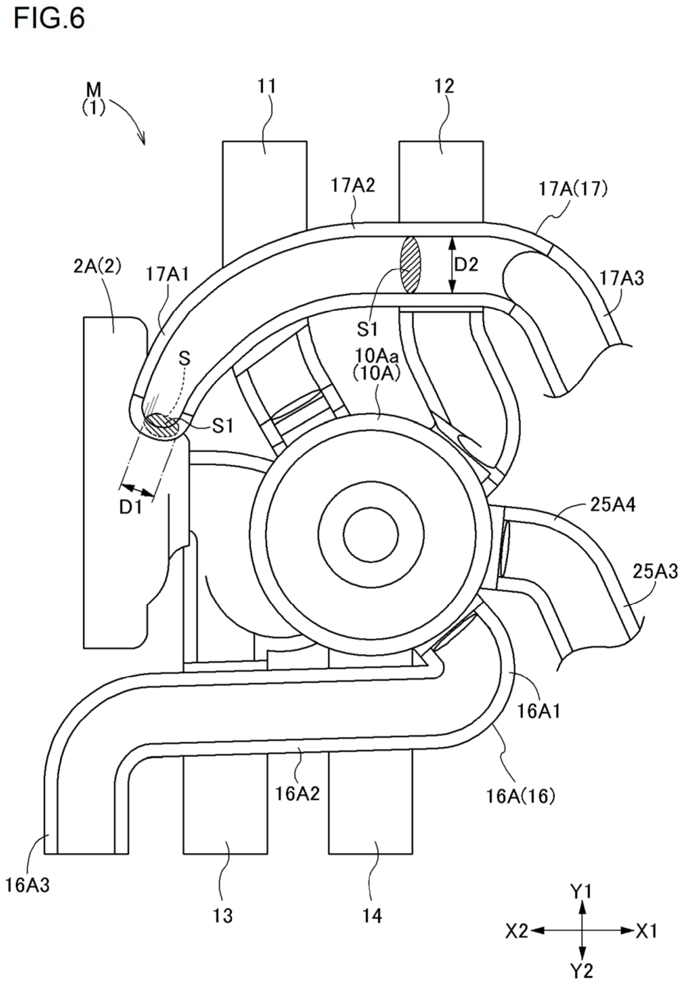

As illustrated in FIG. 6, in the cooling module 1, the manifold M includes the third flow pipe 17 (an example of the circular pipe section) connected to a discharge section S of the water pump 2. A pipe diameter of the third flow pipe 17 is continuously increased toward the downstream side of the water pump 2 in such a way that, assuming a first flow path cross-sectional area S1 at a junction with the discharge section S of the water pump 2 as a reference, a second flow path cross-sectional area S2 of a portion located downstream of the junction with the discharge section S is at least twice the first flow path cross-sectional area S1. Specifically, the third flow pipe 17 is formed in such a way that the pipe diameter (inner diameter of the pipe) is continuously increased from the proximal portion 17A1 to the first intermediate portion 17A2 and a pipe diameter D1 at the junction with the discharge section S equals a pipe diameter D2 of a portion included in the first intermediate portion 17A2.

### (Alternative embodiments)

(1) In the embodiment described above, an example has been illustrated in which in the cooling module 1, the manifold housing 10 and the cover 30, which constitute the manifold M, are formed of the first resin material and the resin-bonded regions E are formed of the second resin material that is different from the first resin material. Alternatively, all of the manifold housing 10, the cover 30, and the resin-bonded regions E may be formed of the same resin material. In this case, the resin-bonded regions E can be formed by means of laser welding, vibration welding, ultrasonic welding, or the like. Again in this case, another member such as a bolt is not required for joining the manifold housing 10 and the cover 30. As a result, a height of the cooling module 1 can be reduced and the number of components can be reduced.
(2) In the embodiment described above, an example has been illustrated in which in the cooling module 1, the manifold housing 10 and the cover 30 are formed of the same resin material. Alternatively, the manifold housing 10 may be formed of the first resin material and the cover 30 may be formed of a resin material that is different from the first resin material. In this case, a resin material appropriate for each section may be selected to configure the cooling module 1, for example, by employing a material having high stiffness for the manifold housing 10 and employing a lightweight resin for the cover 30.
(3) In the embodiment described above, an example has been illustrated in which the manifold housing 10 of the cooling module 1 is formed of a single housing (single member). Alternatively, the housing manifold may be formed of a plurality of members, for example, by resin-bonding two members (an upper housing and a lower housing) disposed in the Z direction.
(4) In the embodiment described above, an example has been illustrated in which the first water pump 2, the second water pump 3, the first rotary valve 4, and the second rotary valve 5 are used as auxiliary devices to be attached to the cooling module 1, however, the auxiliary devices are not limited to these. The cooling module 1 may be configured in such a way that other auxiliary devices are attached thereto. Other examples of the auxiliary devices include: a pump such as a battery-operated pump or a powertrain pump, a chiller, an electric heater, a filter, an aerator, a valve, a connector, a fan, and a radiator.
(5) In the embodiment described above, an example has been illustrated in which the cooling module 1 is configured in such a way that the first inlet port 11, the second inlet port 12, the first outlet port 13, the second outlet port 14, the third inlet port 21, the fourth inlet port 22, the third outlet port 23, the fourth outlet port 24, the fifth outlet port 16, and the flow pipes 15, 17, 25, and 26 are exposed to the outside. Alternatively, the flow path constituted of one or more of these ports and flow pipes may be formed inside the manifold housing 10.
(6) In the embodiment described above, an example has been illustrated in which the cooling module 1 includes the rotary valves 4 and 5, however, the cooling module 1 may include only one rotary valve.
(7) In the embodiment described above, an example has been illustrated in which the single cover 30 covers both of the openings 10Aa and 20Aa of the accommodating sections 10A and 20A. Alternatively, a plurality of the covers 30 may be configured to individually cover openings of a plurality of accommodating sections.
(8) In the embodiment described above, an example has been illustrated in which the two members, i.e., the manifold housing 10 and the cover 30 form the ports and the flow pipes and the bonded surfaces Ma and Mb of the ports and the flow pipes include at least a portion having a curved surface, however, these ports and flow pipes may be formed by joining three or more members.

### (Overview of embodiments described above)

In the embodiments described above, configurations to be described below are conceived. <1> An aspect of a cooling module (1) includes a resin manifold (M) having a coolant flow path through which a cooling fluid circulates, the manifold (M) is formed by joining a first housing (10) and a second housing (30), each of which includes a three-dimensionally curved portion, and a bonded surface (Ma) of the first housing (10) and a bonded surface (Mb) of the second housing (30) include at least a part having a curved surface (Ma1, Mb1).

According to this embodiment, in the cooling module (1), each of the first housing (10) and the second housing (30) includes three-dimensionally curved portions (16A, 16B, 17A, 17B, 25A, 25B) and bonded surfaces (Ma, Mb) of the two housings (10, 30) include at least a part having a curved surface (Ma1, Mb1), and as a result, the manifold (M) has a three-dimensional shape. Consequently, flexibility in shape of the fluid flow path included in the manifold (M) is enhanced, and thus a useless space and a pressure drop in the manifold (M) can be effectively reduced. In addition, temperature in the manifold (M) can be efficiently controlled with a small amount of water. As a result, the cooling module (1) can enable a cooling liquid to efficiently circulate in the manifold (M).

<2> In the cooling module (1) of <1>, the manifold (M) may include circular pipe sections (16, 17, 25) that are formed by resin-bonding the three-dimensionally curved portions (16A, 16B, 17A, 17B, 25A, 25B), and at least a part of the coolant flow path may be formed of the circular pipe sections (16, 17, 25).

The cooling module (1) includes a plurality of flow paths in the manifold (M). In such flow paths, flexibility in shape is enhanced by forming the flow paths in such a way as to be exposed to an outside of the manifold (M). In addition, the circular pipe sections (16, 17, 25) formed by resin-bonding the three-dimensionally curved portions (16A, 16B, 17A, 17B, 25A, 25B) can be used as the flow paths. Further, by using the circular pipe sections (16, 17, 25) as the flow paths, a pressure drop in the flow path can be more effectively reduced.

<3> In the cooling module (1) of <1> or <2>, one end of the manifold (M) may be connected to a discharge section (S) of a water pump (2), and a pipe diameter of the circular pipe section (17) may be continuously increased toward a downstream side in such a way that, assuming a first flow path cross-sectional area (S1) at a junction with the discharge section (S) as a reference, a second flow path cross-sectional area (S2) of a portion located downstream of the junction with the discharge section (S) is at least twice the first flow path cross-sectional area (S1).

According to this embodiment, in the circular pipe section (17) connected to the discharge section (S) of the water pump (2), the second flow path cross-sectional area (S2) of a portion located downstream of the junction with the discharge section (S) is larger than the first flow path cross-sectional area (S1) at the junction with the discharge section (S), and a pipe diameter of the circular pipe section (17) is continuously increased in such a way that the second flow path cross-sectional area (S2) is at least twice the first flow path cross-sectional area (S1). Consequently, even when the circular pipe section (17) is a relatively short pipe section, a refrigerant can be smoothly circulated from the discharge section (S) of the water pump (2) toward the circular pipe section (17). As a result, a pressure drop in the circular pipe section (17) can be more effectively reduced.

<4> In the cooling module (1) of <1> or <2>, the first housing (10) and the second housing (30) of the manifold (M) may be formed of a first resin material, and the three-dimensionally curved portions (16A, 16B, 17A, 17B, 25A, 25B) may be resin-bonded by using a second resin material being different from the first resin material.

According to this embodiment, in the cooling module (1), the first resin material for forming the first housing (10) and the second housing (30) and the second resin material to be used for resin-bonding these housings are different. Therefore, the cooling module (1) can be formed, for example, by means of the DSI (Die Slide Injection) method. By using the DSI method, even when an internal structure of the manifold (M) in the cooling module (1) is a complex hollow body, the cooling module (1) can be molded with high precision.

## Claims

1. A cooling module (1) comprising
a resin manifold (M) having a coolant flow path through which a cooling fluid circulates, wherein
the manifold (M) is formed by joining a first housing (10) and a second housing (30), each of which includes a three-dimensionally curved portion (16A, 16B, 17A, 17B, 25A, 25B), and
a bonded surface (Ma) of the first housing (10) and a bonded surface (Mb) of the second housing (30) include at least a part having a curved surface (Ma1, Mb1).

2. The cooling module (1) according to Claim 1, wherein
the manifold (M) includes a circular pipe section (16, 17, 25) being formed by resin-bonding the three-dimensionally curved portions (16A, 16B, 17A, 17B, 25A, 25B), and
at least a part of the coolant flow path is formed of the circular pipe section (16, 17, 25).

3. The cooling module (1) according to Claim 2, wherein
one end of the circular pipe section (16, 17, 25) is connected to a discharge section (S) of a water pump (2), and
a pipe diameter of the circular pipe section (16, 17, 25) is continuously increased toward a downstream side in such a way that, assuming a first flow path cross-sectional area (S1) at a junction with the discharge section (S) as a reference, a second flow path cross-sectional area (S2) of a portion located downstream of the junction with the discharge section (S) is at least twice the first flow path cross-sectional area (S1).

4. The cooling module (1) according to any one of Claims 1 to 3, wherein
the first housing (10) and the second housing (30) of the manifold (M) are formed of a first resin material, and
the three-dimensionally curved portions (16A, 16B, 17A, 17B, 25A, 25B) are resin-bonded by using a second resin material being different from the first resin material.
